# EUROPEAN PATENT SPECIFICATION

(11) **EP 2 688 850 B1**
(45) Date of publication and mention of the grant of the patent: **21.02.2018**
(21) Application number: 12714114.1
(22) Date of filing: 22.03.2012
(51) Int. Cl.: C23C 16/40, C23C 16/54, C23C 16/455, C03C 17/245, C03C 17/00

(54) **METHOD OF DEPOSITING ZINC OXIDE COATINGS BY CHEMICAL VAPOR DEPOSITION**
VERFAHREN ZUR ABLAGERUNG VON ZINKOXIDBESCHICHTUNGEN MITTELS CVD
PROCÉDÉ DE DÉPÔT DE REVÊTEMENTS D'OXYDE DE ZINC PAR DÉPÔT CHIMIQUE EN PHASE VAPEUR

(30) Priority: 23.03.2011 US 201161466498 P
(43) Date of publication of application: 29.01.2014
(73) Proprietor: Pilkington Group Limited, Lathom, near Ormskirk, Lancashire L40 5UF (GB)
(72) Inventor: SANDERSON, Kevin D., Upholland Wigan WN8 0BQ (GB); SOUBEYRAND, Michel J., Holland, OH 43528 (US); NELSON, Douglas M., Curtice, OH 43412 (US); SETO, Yasunori, Tokyo 108-6321 (JP); TSURI, Keiko, Tokyo 108-6321 (JP)
(74) Representative: Denno, Richard Christopher Somer
(86) International application number: PCT/US2012/030032
(87) International publication number: WO 2012/129358

(56) References cited:
- EP-A2- 0 611 733
- WO-A1-2008/027085
- WO-A2-02/46242
- US-A- 5 136 975
- US-A1- 2009 081 885
- US-A1- 2009 214 858
- US-A1- 2010 143 588

## Description

### CROSS-REFERENCE TO RELATED APPLICATION

This application is claiming the benefit of the provisional application which was granted Serial No. 61/466,498 filed on March 23, 2011.

### BACKGROUND OF THE INVENTION

The invention relates to a process for efficiently depositing zinc oxide coatings. More specifically, the invention relates to a CVD process of depositing zinc oxide coatings having desired properties on a glass substrate at commercially viable deposition rates.

Two categories of thin films have been known for some years. They are distinguishable in many ways, but for purposes of this application, the primary areas of distinction are: (1) the method of deposition, i.e. on-line versus off-line and (2) the types of films generally produced by such methods, respectively, hard coat (or pyrolytic) versus soft coat.

On-line coatings are typically produced by deposition of one or more thin film layers on, for example, a glass substrate during the glass manufacturing process, preferably, a continuous float glass manufacturing process. As a consequence of the characteristics of the float glass manufacturing process, the thin film deposition process must take place at relatively high temperatures, with very short chemical reaction times, but at high deposition rates, in order to be commercially viable. In a successful on-line coating operation, the thin films produced are relatively mechanically and chemically durable compared to most soft coat films.

Off-line film deposition, by contrast, typically involves one of several known types of sputter coating processes, in which glass panels are placed in one or more low pressure coating chambers where the glass panel is exposed to an atmosphere created by the physical or chemical reaction of a "target" material so that it is deposited on a surface of the glass panel. As the sputtering process is not controlled by the speed of the glass manufacturing process, it may be possible to deposit more complex film stacks by sputtering processes, which film stacks may, in some instances have properties superior to those of pyrolytic films, but such sputtered films are also likely to be significantly more expensive to produce since the sputtering process must done in a vacuum chamber.

Methods of depositing thin film coatings on glass substrates are known in the patent literature, for example:
US Patent No. 4,834,020 describes a conveyorized APCVD apparatus having a heated muffle furnace and a conveyor belt for conveying objects to be coated through the furnace. At least one chemical vapor deposition zone is provided in the muffle furnace. An injector assembly is also provided for uniformly injecting first and second reactant gases in the deposition zone across the width of the conveyor belt and against the surfaces of the objects to be coated. The gases exit from the slots connected to distribution plenums. Polished cooled surfaces are used on the injector assembly for the purpose of minimizing deposition of chemicals thereon.

US Patent No. 5,136,975 describes an injector of a type said to be used in APCVD equipment. The injector includes a number of plates with a number of linear hole arrays. The plates are layered in order to produce a number of what are called cascaded hole arrays. The layered plates together are said to define a hole matrix. A chute is positioned beneath the hole matrix. On both sides of the chute is a cooling plate. The chute includes a passage and the regions between the cooling plates and the chute form ducts. The top of the hole matrix receives a number of gaseous chemicals and discretely conveys them to the top of the individual cascade hole arrays. The gaseous chemicals are then forced through the cascaded hole arrays which induces the gases to flow in an increasingly uniform manner. The gaseous chemicals are then individually fed to the passage and ducts which convey them to a region above the surface where the chemicals are exposed to one another, react, and form a layer on a substrate surface.

US Patent No. 5,206,089 describes a transparent conductive layer of metal oxide comprised primarily of a mixed oxide of zinc and indium deposited on a glass substrate by, for example, a method wherein the substrate is heated to a temperature less than the glass-softening temperature, a suspension in a vector gas of a mixture of powders thermally decomposable at the temperature of the substrate is formed of an organic compound of zinc and an organic compound of indium, which is pyrolyzed on contact with the substrate, forming a layer of a mixed oxide of zinc and indium. Substrate temperatures are said to be between 500°C and 700°C, preferably between 600°C and 650°C.

US Patent No. 6,206,973 describes a CVD system including a heated muffle, a chamber having an injector assembly for introducing vaporized chemical reactants, and a belt for moving the substrate through the muffle and chamber. The belt has an oxidation-resistant coating to reduce formation of deposits thereon, particularly deposits of chromium oxides.

US Patent No. 6,521,048 describes a CVD apparatus comprising a deposition chamber and a main chamber. The deposition chamber comprises a least one single injector and one or more exhaust channels. The main chamber supports the deposition chamber and includes at least one gas inlet to inject at least one gas into the main chamber. The gases are removed through the exhaust channels thereby creating an inwardly flowing purge which acts to isolate the deposition chamber. At least one so-called semi -seal is formed between the deposition chamber and the substrate so as to confine the reactive chemicals within each deposition region.

US Patent No. 6,890,386 describes an injector and exhaust assembly for delivering gas to a substrate comprising at least two injectors positioned adjacent each other and spaced apart to form at least one exhaust channel therebetween, and a mounting plate for securing the at least two injectors, wherein each of the at least two injectors are individually mounted to or removed from the mounting plate, the mounting plate being provided with at least one exhaust slot in fluid communication with the at least one exhaust channel. An exhaust assembly is coupled to the mounting plate to remove exhaust gases from the injectors.

WO2008/027085 describes a method of depositing a doped zinc oxide coating on a transparent substrate using an APCVD coating apparatus having two separate conduits for feeding reactants to a mixing chamber to be deposited on the substrate surface.

### BRIEF SUMMARY OF THE INVENTION

A chemical vapor deposition process for depositing a zinc oxide coating is provided.

In an embodiment according to the invention, the process comprises providing a glass substrate at a temperature above 1112°F (600°C) and a coating apparatus above the glass substrate. The coating apparatus comprises two or more separate flow pathways. Each flow pathway provides communication between an inlet opening and an outlet opening, and one or more flow conditioners disposed in each of the flow pathways. The process comprises providing gaseous precursor compounds including gaseous zinc-containing compound, a gaseous oxygen-containing compound, and a gaseous acetonate compound and one and more inert gases. The process also comprises introducing the gaseous precursor compounds and the one or more inert gases as two or more streams into the inlet openings. The streams are directed through the two or more separate flow pathways and discharged from the outlet openings of the coating apparatus. The gaseous precursor compounds and one or more inert gases mix to form a zinc oxide coating on a surface of the glass substrate. At least one of the one or more flow conditioners has a honeycomb configuration.

In another embodiment, the process for depositing a zinc oxide coating comprises providing a moving heated glass substrate which is at essentially atmospheric pressure and supported on a bath of molten metal in a float glass manufacturing process. A coating apparatus is provided at, at least, one predetermined location in the float bath chamber and at a predetermined distance above the heated moving glass substrate. The process for depositing the zinc oxide coating also comprises providing a source of a gaseous zinc-containing compound, a gaseous oxygen-containing compound, one or more inert gases, and gaseous acetyl acetonate. A gaseous stream comprising the gaseous zinc-containing compound is introduced into a first flow pathway in the coating apparatus. A gaseous stream comprising the gaseous oxygen-containing compound is introduced into a second flow pathway in the coating apparatus. A gaseous stream comprising the inert gas is introduced into a third flow pathway in the coating apparatus and the gaseous acetyl acetonate is also introduced into a flow pathway in the coating apparatus. The streams of gaseous compounds/inert gases are maintained separate while each flows through a flow conditioner at a predetermined flow velocity to increase the laminarity of each stream. The separate streams of gaseous compounds/inert gases are discharged from each flow conditioner and mixing of the separate streams of gaseous compounds/inert gases occurs to form a pyrolytic zinc oxide coating on a surface of the glass substrate.

### BRIEF DESCRIPTION OF THE SEVERAL VIEWS OF THE DRAWINGS

The above, as well as other advantages of the present invention will become readily apparent to those skilled in the art from the following detailed description when considered in the light of the accompanying drawings in which:
Fig. 1 shows a schematic view of a float glass manufacturing operation;
Fig. 2 shows a front plan view of a coating apparatus according to an embodiment of the invention;
Fig. 3 shows an end plan view of a coating apparatus according to an embodiment of the invention;
Fig. 4 shows a cross-sectional view of a coating apparatus according to an embodiment of the invention;
Fig. 5 shows a cross-sectional view of a coating apparatus according to an embodiment of the invention;
Fig. 6 shows a cross-sectional view of a coating apparatus according to an embodiment of the invention;
Fig. 7 shows a cross-sectional view of a coating apparatus according to an embodiment of the invention;
Fig. 8 shows a perspective view of a portion of a coating apparatus according to an embodiment of the invention;
Fig. 9 shows an enlarged view of a portion of the coating apparatus shown in Fig. 8 according to an embodiment of the invention; and
Fig. 10 shows a cross-sectional view of the portion of the coating apparatus shown in Fig. 9 according to an embodiment of the invention.

### DETAILED DESCRIPTION OF THE INVENTION

It is to be understood that the invention may assume various alternative orientations and step sequences, except where expressly specified to the contrary. It is also to be understood that the specific articles, apparatuses and processes illustrated in the attached drawings, and described in the following specification are simply exemplary embodiments of the inventive concepts. Hence, specific dimensions, directions, or other physical characteristics relating to the embodiments disclosed are not to be considered as limiting, unless expressly stated otherwise.

In an embodiment, a chemical vapor deposition (CVD) process for depositing a coating of zinc oxide on a glass substrate 12 is provided. As such, certain embodiments will be described in connection with forming a coated glass article. The coated glass article may have many uses and/or can be used in many applications. For example, the coated glass article may be used as a superstrate in the manufacture of solar cells. However, it would be understood by one of ordinary skill in the art that the coated glass article could also be utilized as a substrate in the manufacture of solar cells. Furthermore, the coated glass article described herein is not limited to use in solar cell applications. For example, in certain embodiments the zinc oxide coating may be suitable as a low emissivity or solar control coating. Thus, the coated glass article may be utilized in architectural glazings. The coated glass article may also be utilized in electronics and/or have automotive and aerospace applications.

In certain embodiments, the zinc oxide coating contains primarily zinc and oxygen (ZnO), and possibly containing trace contaminants of, for example, of carbon. In other embodiments, the zinc oxide coating may be doped (ZnO:X) or co-doped (ZnO:X:Y) such that it includes zinc, oxygen and at least one dopant material. Suitable dopant materials include, for example, aluminum, boron, silicon, gallium, fluorine and/or combinations thereof. Those skilled in the art would appreciate that other dopant materials are also suitable for use as a dopant in the zinc oxide coating. In an embodiment, the zinc oxide coating is a pyrolytic zinc oxide coating.

The CVD process for depositing the coating of zinc oxide comprises providing the glass substrate 12. In an embodiment, the glass substrate 12 is a soda-lime-silica glass. In this embodiment, the glass substrate 12 may be substantially transparent. However, the invention is not limited to soda-lime-silica glass substrates as, in certain embodiments, the glass substrate 12 may be a borosilicate glass. Additionally, the invention is not limited to transparent glass substrates as translucent glass substrates may also be utilized in practicing the CVD process. Furthermore, the transparency or absorption characteristics of the glass substrate 12 utilized may vary between embodiments of the invention. Likewise, the invention is not limited to a particular glass substrate composition. For example, it may be preferable to utilize a glass substrate having a low iron content in the CVD process described herein. Additionally, the invention can be practiced utilizing clear, blue, green, grey, and bronze colored glass substrates and is not limited to a particular glass substrate thickness.

In certain embodiments, the CVD process may be practiced under dynamic deposition conditions. Thus, the CVD process may comprise providing a glass substrate 12 which is moving during formation of the zinc oxide coating. In these embodiments, the zinc oxide coating may be formed while the glass substrate 12 moves at a predetermined rate of, for example, > 3.175 meters per minute (m/min) (125 in/min). In another embodiment, the glass substrate 12 is moving at a rate of between 3.175 m/min (125 in/min) and 12.7 m/min (600 in/min) while the zinc oxide coating is being formed.

In certain embodiments, the glass substrate 12 is heated. In these embodiments, the temperature of the glass substrate 12 may be heated to between about 1050°F (566°C) and 1400°F (750°C) when the zinc oxide coating is formed thereover or thereon. In certain embodiments, the temperature of the glass substrate 12 is at or above 1112°F (600°C) when the zinc oxide coating is formed thereon. Preferably, the glass substrate 12 is heated to between about 1112°F (600°C) and 1346°F (730°C) when the zinc oxide coating is formed thereon. In a more specific embodiment, the glass substrate 12 is heated to between about 1112°F (600°C) and 1202°F (650°C) when the zinc oxide coating is formed thereon. Thus, the CVD process surprisingly allows for the formation of zinc oxide coatings at high deposition temperatures.

The CVD process for depositing the coating of zinc oxide may be carried out in conjunction with the manufacture of the glass substrate 12. For instance, the zinc oxide coating may be deposited on the glass substrate 12 during the formation of the glass substrate. Thus, the glass substrate 12 may be a glass ribbon formed utilizing the well-known float glass manufacturing process. Additionally, in an embodiment, a surface 14 of the glass substrate 12 may be at essentially atmospheric pressure when the zinc oxide coating is formed thereover or thereon. Thus, in this embodiment, the CVD process is an atmospheric pressure CVD (APCVD) process.

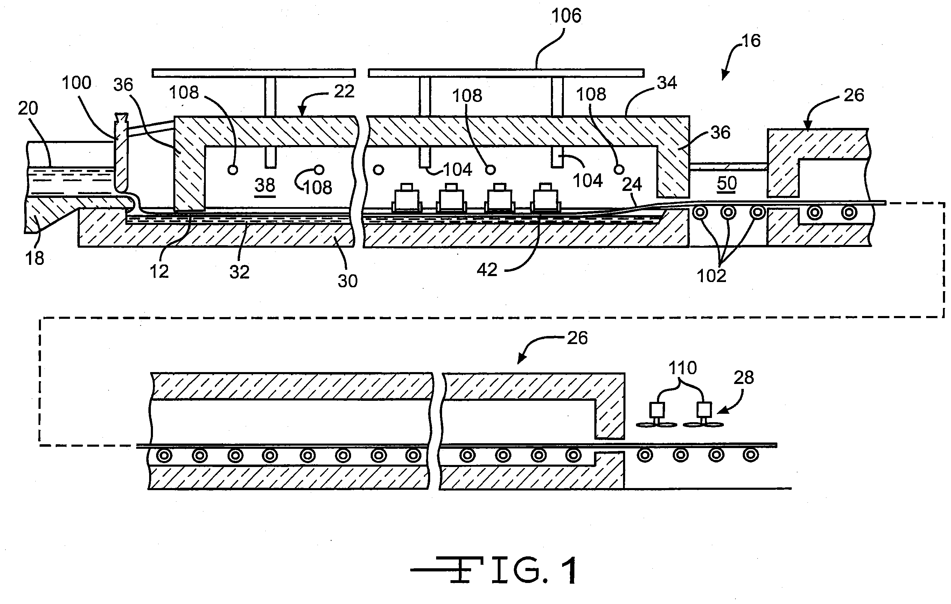

An exemplary illustration of a float glass manufacturing process is shown in Fig. 1. As the float glass installation 16 described herein and shown in Fig. 1 is only illustrative of such installations, it is not limiting as to the invention.

As illustrated in Fig. 1, the float glass installation 16 may comprise a canal section 18 along which molten glass 20 is delivered from a melting furnace, to a float bath section 22 wherein a continuous glass ribbon 24 is formed in accordance with the well-known float glass process. The glass ribbon 24 advances from the float bath section 22 through an adjacent annealing lehr 26 and a cooling section 28. The float bath section 22 includes a bottom section 30 within which a bath of molten tin 32 is contained, a roof 34, opposite sidewalls (not shown) and end walls 36. The roof 34, sidewalls and end walls 36 together define a chamber 38 in which a non-oxidizing atmosphere is maintained to prevent oxidation of the molten tin 32.

The CVD process for depositing the coating of zinc oxide may comprise providing a source of a gaseous zinc-containing compound, a source of a gaseous oxygen-containing compound, a source of one or more gaseous additive compounds, a source of one or more inert gases, and, optionally, a source of one or more gaseous dopant compounds. In an embodiment, the sources (not depicted) are provided at a location outside the float bath chamber 38. Separate supply lines (not depicted) may extend from the sources of gaseous reactant (precursor) compounds and, similarly, from the source(s) of inert gas(es).

As used herein, the phrases "gaseous reactant compound" and "gaseous precursor compound" may be used interchangeably to refer any or all of the gaseous zinc-containing compound, the gaseous oxygen-containing compound, and the one or more gaseous additive compounds. Additionally, when the one or more gaseous dopant compounds are specifically described as being included in an embodiment, the phrases "gaseous reactant compound" and/or "gaseous precursor compound" may also refer thereto as well.

As would be appreciated by those skilled in the art, the materials suitable for use as the gaseous zinc-containing compound, the gaseous oxygen-containing compound, the additive compound(s) and the optional one or more dopant compounds should be suitable for use in a CVD process and in certain embodiments an APCVD process. Such materials may at some point be a liquid or a solid but are volatile such that they can be vaporized to a gaseous state for use in a CVD process. Once in a gaseous state, the gaseous precursor compounds are included in a gaseous stream and introduced, via inlet openings 40, into a coating apparatus 42.

The zinc oxide coatings formed by the CVD process described herein may utilize any combination of suitable gaseous precursor compounds. However, in an embodiment, the zinc-containing compound is an organic zinc-containing compound.

Suitable organic zinc-containing compounds for use in practicing the CVD process include compounds of the general formula R¹R²Zn, R¹R²ZnL_{z} or R¹R²Zn-[R³R⁴N(CHR⁵)ₙ(CH₂)ₘ(CHR⁶)ₙNR⁷R⁸], where
R¹⁻⁸ can be the same or different alkyl or aryl groups such as methyl, ethyl, isopropyl, n-propyl, n-butyl, sec-butyl, phenyl or substituted phenyl, and may include one or more fluorine-containing substituents;
L is an oxygen-based, commercial, neutral ligand such as tetrahydrofuran, methyl trihydrofuran, furan, diethyl or dibutyl ether, methyl tert-butyl ether, or dioxane and z=1-2;
R⁵ and R⁶ can be H or alkyl or aryl groups, n can be 0 or 1, and m can be 1-6 if n is 0, and m can be 0-6 if n is 1;
Preferred zinc containing compounds include diethyl and dimethyl zinc adducts (such as) diethylzinc·TEEDA (TEEDA = N,N,N',N'-tetraethyl ethylenediamine), diethylzinc·TMEDA (TMEDA = N,N,N',N'-tetramethyl ethylenediamine),diethylzinc·TMPDA (TMPDA = N,N,N',N'-tetramethyl-1,3-propanediamine), dimethylzinc·TEEDA, dimethylzinc·TMEDA, and dimethylzinc·TMPDA.
Other suitable organic zinc-containing compounds include dialkyl zinc glycol alkyl ether of the formula
R⁹₂Zn•[R¹⁰O(CH₂)₂O(CH₂)₂OR¹⁰], whereR⁹ is a short chain, saturated organic group having 1 to 4 carbon atoms and R¹⁰ is a short chain, saturated organic group having 1 to 4 carbon atoms. Preferably, R⁹ is a methyl or ethyl group (C₂H₅-) and R¹⁰ is a methyl group (CH₃-) and is referred to as diethylzinc (DEZ) diglyme having the formula:

   Et₂Zn•[CH₃O(CH₂)₂O(CH₂)₂OCH₃]

Other tridentate ligands capable of chelating the dialkyl zinc moiety that may be useful in connection with the present invention include: compounds of the formula [R¹¹C(OR¹²)₃] where R¹¹ is H or a short chain, saturated organic group having 1 to 4 carbon atoms or a phenyl group and R¹² is a short chain, saturated organic group having 1 to 4 carbon atoms as described above, where R¹¹ and R¹² may be the same or different, triamine ligands of the formula [R¹³₂N(CH₂)₂N(R¹⁴)(CH₂)₂NR¹³₂] where R¹³ is a short chain, saturated organic group having 1 to 4 carbon atoms and compounds where R¹⁴ = a phenyl group (C₆H₅) or a substituted phenyl group. Diphenyl zinc compounds may also be useful in connection with the present invention.

Most preferably, the organic zinc-containing compound is an alkyl zinc compound such as diethyl zinc (DEZ) or, preferably, dimethyl zinc (DMZ). However, it should be appreciated that the zinc-containing compound need not be an organic zinc-containing compound to practice the CVD process.

In an embodiment, the oxygen-containing compound is an inorganic oxygen-containing compound. For example, the inorganic oxygen-containing compound may be water (H₂O), carbon dioxide (CO₂), nitric oxide (NO), nitrogen dioxide (NO₂), nitrous oxide (N₂O), oxygen (O₂) or mixtures thereof. However, it should be appreciated that additional inorganic oxygen-containing compounds may be suitable for practicing the invention.

In a preferable embodiment, the oxygen-containing compound is H₂O. In another embodiment, the oxygen-containing compound is one selected from the group consisting of H₂O, CO₂, NO, NO₂, N₂O, O₂ and mixtures thereof. When the oxygen-containing compound is H₂O it is preferably provided as steam. When the oxygen-containing compound is O₂ it may be provided as a part of a gaseous composition such as air or in a substantially purified form. In either case, O₂ is in the form of molecular oxygen.

In an embodiment, the one or more additive compounds is an organic additive compound. In another embodiment, the one or more additive compounds is an organic oxygen-containing additive compound. In this embodiment, the preferred organic oxygen-containing additive compound is an acetonate compound. Specifically, in an embodiment, the additive compound is acetyl acetonate. However, in other embodiments, the one or more additive compounds may be derivative of acetyl acetonate. For example, trifluoroacetylacetonate and/or hexafluoroacetylacetonate may be utilized as additive compound(s). As will be below-described, additional additive compounds may be suitable for use in practicing certain embodiments of the CVD process. Also, as should be appreciated, alternative organic additive compounds and organic oxygen-containing additive compounds may also be suitable for use in the CVD process for depositing the coating of zinc oxide.

While not wishing to be bound to a specific a theory of operation, it is believed that the one or more additive compounds act as a reaction rate modifier in the CVD process. As a rate modifier, the one or more additive compounds may temporarily reduce the rate of reaction between the gaseous zinc-containing and oxygen-containing compounds. As will be below-described, mixing of the gaseous streams occurs once the gaseous streams are discharged from the coating apparatus 42. As such, it would not be desirable for the gaseous zinc-containing compound and the oxygen-containing compound(s) to begin reacting to form zinc oxide prior to reaching the surface 14 of the glass substrate 12 to be coated. Therefore, a beneficial aspect of a temporary reduction in reaction rate between said constituents would be that the gaseous streams could begin mixing without prematurely reacting before they reached the surface 14 of the glass substrate 12 to be coated. It is also believed that the one or more additive compounds may enhance nucleation of the zinc oxide coating on the surface 14 of the glass substrate 12 to be coated.

Suitable inert gases include nitrogen (N₂), hydrogen (H₂), helium (He) and mixtures thereof. Thus, in an embodiment, the one or more inert gases are selected from the group consisting of N2, H2, He and mixtures thereof. In certain embodiments, a stream or plurality of streams may be composed primarily of inert gas(es) and possibly only small percentages of certain impurities such as H₂O vapor. However, for a stream having a least one gaseous precursor compound, it should be appreciated that one or more inert gases may be provided in the stream to act as a carrier/diluent gas. Thus, in an embodiment, N2, H2, He or mixtures thereof are included in a gaseous stream which also comprises at least one gaseous precursor compound.

Additionally, it may be desirable to impart the property of low electrical resistivity to the zinc oxide coating. This can be accomplished by utilizing at least one gaseous dopant compound. Dopant compounds suitable for use in the CVD process include gallium-containing compounds, aluminum-containing compounds, boron-containing compounds, silicon-containing compounds, fluorine-containing compounds and combinations thereof. In certain embodiments, the gallium-containing dopant compound may be trimethyl gallium (TMG) and in other embodiments the gallium-containing dopant compound may be gallium trichloride (GaCl₃). In embodiments where an aluminum-containing dopant compound is utilized, the aluminum-containing dopant compound may be aluminum trisisopropoxide, dimethyl aluminum chloride and aluminum trichloride.

When using at least one dopant compound, it may be desirable to use a second gaseous additive compound. In an embodiment, where a gallium-containing dopant compound such as GACl₃ is provided in a stream, a second additive compound such as hydrogen chloride (HCI) may also be provided in a stream. Preferably, HCI is provided in the stream which also comprises the gallium-containing dopant compound. It should be appreciated that when a second additive compound is included in a gaseous stream that it is in a gaseous state.

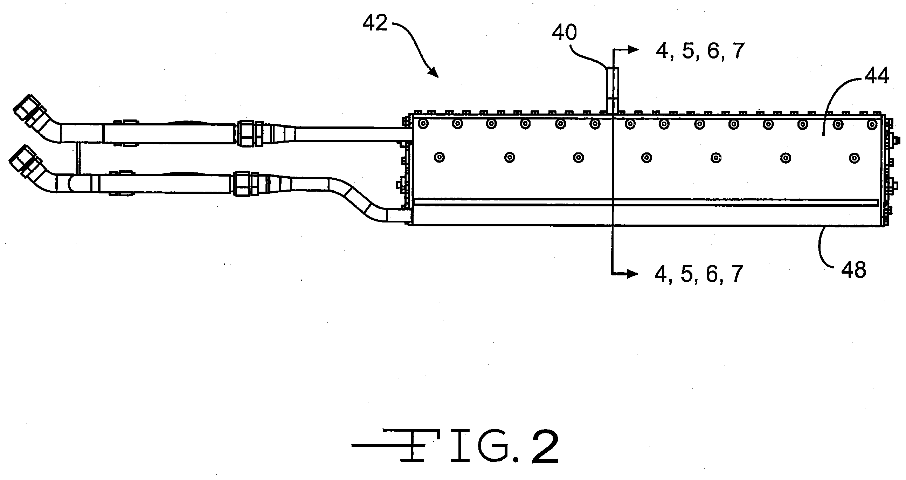

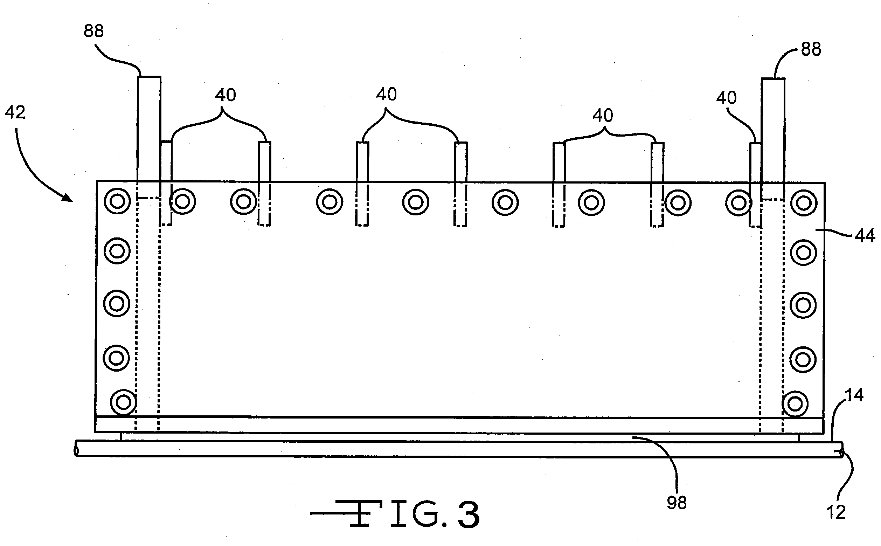

Additionally, the CVD process for depositing the coating of zinc oxide comprises providing the coating apparatus 42 above the glass substrate. A coating apparatus suitable for use in the CVD process is illustrated in Figs. 2 - 10. Also, a description of a coating apparatus suitable for practicing the present invention can be found in U.S. patent application serial no. 61/466,501, the entire disclosure of which is hereby incorporated by reference.

In certain embodiments, the coating apparatus 42 comprises a main body 44. The main body 44 comprises at least a pair of sidewalls 46, 46 and at least one face 48. Preferably, the main body 44 comprises a pair of faces 48, 48 with each face 48 being attached to a sidewall 46. When the coating apparatus 42 comprises a pair of faces 48, 48, each face 48 is aligned with the other and positioned in a parallel relationship with the glass substrate 12. In this embodiment, the at least a pair of sidewalls 46, 46 are in a perpendicular relationship with the glass substrate 12.

In an embodiment, the coating apparatus 42 is provided at a predetermined distance above the glass substrate 12. As shown in Fig. 1, when a plurality of coating apparatuses are provided each may be at a predetermined distance above the glass substrate 12. More specifically, in an embodiment, the main body 44 is provided at a predetermined distance above the glass substrate 12 and extends transversely over the substrate 12. As measured from the at least one face 48 of the main body 44, the coating apparatus 42 is at a predetermined distance above the glass substrate 12 of from about 2 - 30 millimeters (mm). More preferably, as measured from the at least one face 48, the coating apparatus 42 is at a predetermined distance above the glass substrate 12 of from about 2 - 10 mm.

The coating apparatus 42 is preferably located at, at least, one predetermined location. As shown in Fig. 1, when the glass substrate 12 is a glass ribbon formed in the float glass manufacturing process, the coating apparatus 42 may be located in the float bath chamber 38. Fig. 1 shows four coating apparatuses provided in the float bath chamber 38. However, it should be appreciated that when the invention is utilized in conjunction with the float glass manufacturing process, the coating apparatus 42 may be provided within the float bath section 22, the annealing lehr 26, and/or in a gap 50 between the float bath section 22 and the annealing lehr 26.

The coating apparatus 42 of the CVD process is utilized so that the various gaseous streams are kept separate, are preferably conditioned to a desired degree of laminarity, and, in certain embodiments, are maintained within a desired temperature range as they flow through the coating apparatus 42 in preparation for discharge from the coating apparatus 42 above the surface 14 of the glass substrate 12.

As above-described, separate supply lines extend from the sources of gaseous reactant (precursor) compounds and, similarly, from the source(s) of inert gas(es). The supply lines extend to the inlet openings 40 in the coating apparatus 42.

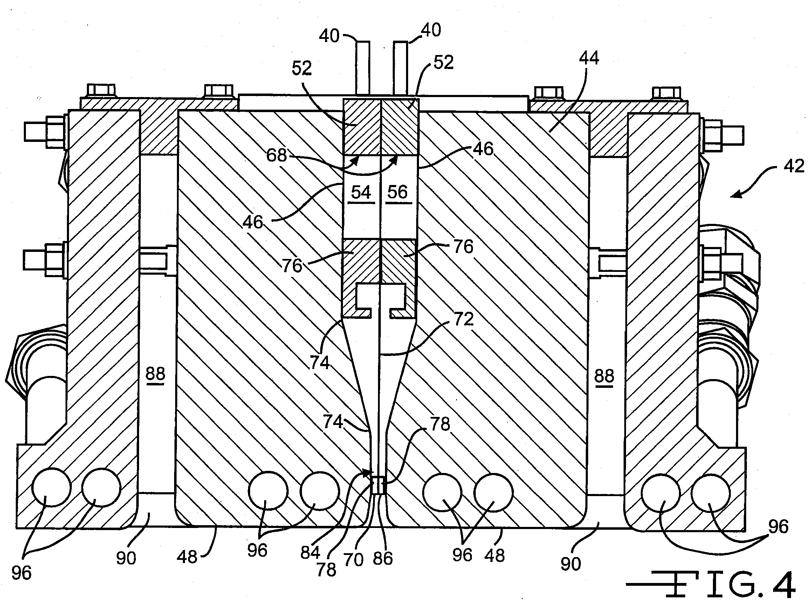

As illustrated in Figs. 4 - 7, each inlet opening 40 extends through a cover block 52 to communicate with a flow pathway 54 provided within the coating apparatus 42. In an embodiment, a cover block 52 is provided for each flow pathway 54 - 66. Thus, the coating apparatus 42 may comprise a plurality of cover blocks 52. In certain embodiments, the cover blocks 52 are positioned at an end 68 of the flow pathway opposite an outlet opening 70 where the streams of gaseous precursor compounds/inert gases are discharged from the coating apparatus 42.

Each flow pathway 54 - 66 is separate and discrete being designed to keep the various streams apart from one another in the coating apparatus 42. In an embodiment like the one illustrated in Fig. 4, the coating apparatus 42 comprises two or more separate flow pathways 54, 56. Additionally, in certain embodiments, the two or more flow pathways 54, 56 extend through the main body 44. In an embodiment, the coating apparatus 42, specifically the main body 44, at least partially defines two flow pathways 54, 56.

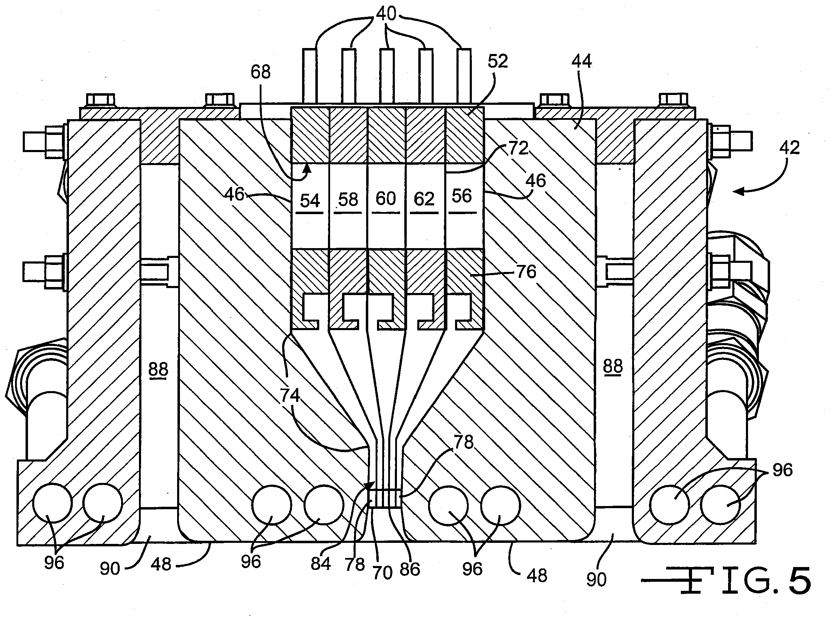

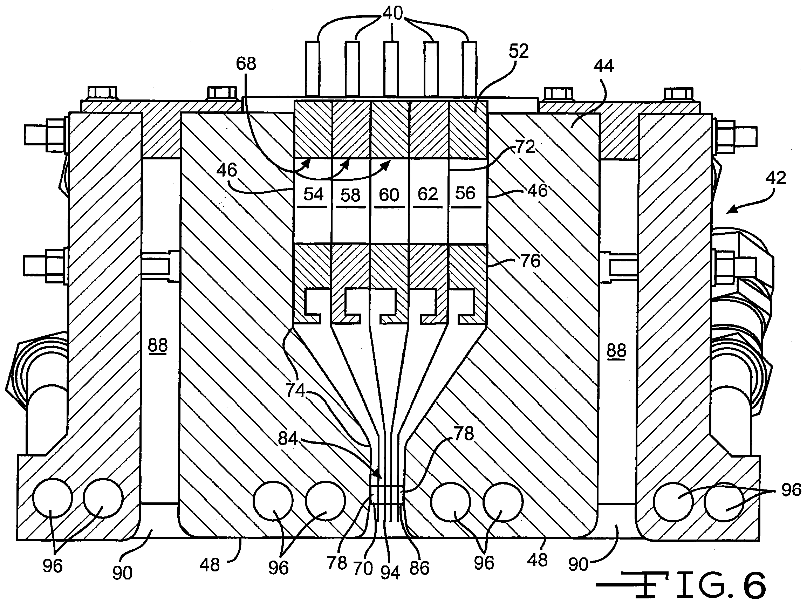

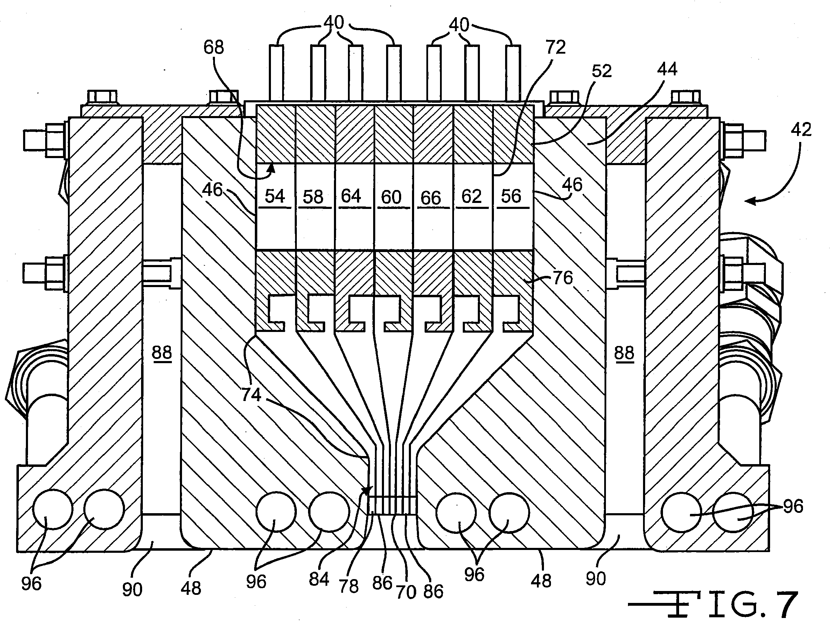

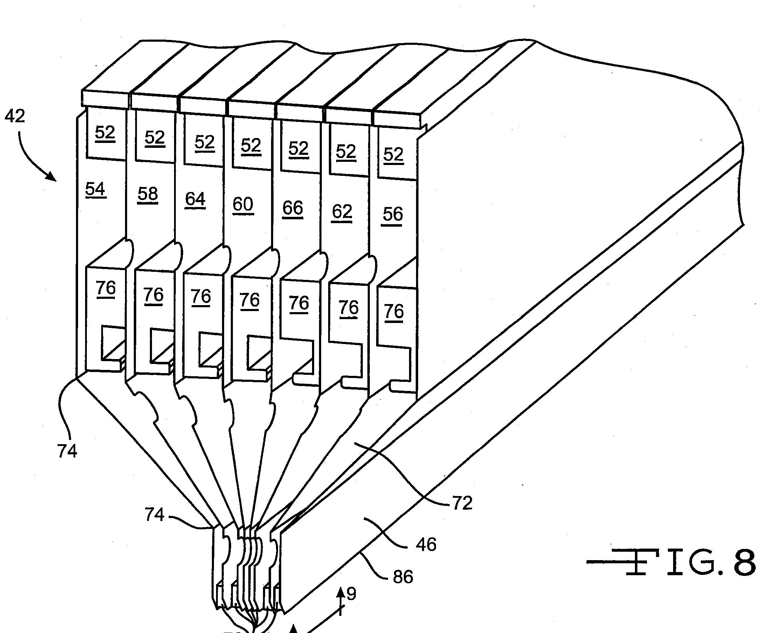

In an embodiment, the two or more flow pathways 54, 56 are at least partially defined by sidewalls 46 of the main body 44 and a gas flow separator 72 positioned between by the sidewalls 46. Thus, in an embodiment, the coating apparatus 42 comprises at least one gas flow separator 72. However, the coating apparatus may have many more than two flow pathways 54, 56. As shown in Figs. 5 and 6, the coating apparatus may have five or more flow pathways 54 - 62. Additionally, as shown in Figs. 7 and 8, the coating apparatus may have seven or more flow pathways 54 - 66. Thus, as illustrated, in certain embodiments the flow pathways 54 - 66 may be defined at least partially by the sidewalls 46 of the main body 44 and a gas flow separator 72 and at least partially by adjacent gas flow separators 72. Thus, the coating apparatus 42 may comprise a plurality of gas flow separators 72.

The streams of gaseous precursor compounds/inert gases are directed through and flow at a predetermined velocity through the flow pathways 54 - 66. The velocities at which the streams of gaseous precursor compounds/inert gases flow may be influenced by the configuration of the flow pathways 54 - 66. As such, the velocity of a gaseous stream may be the same, substantially equal or different from a gaseous stream in an adjacent flow pathway. Also, the flow rate of a gaseous stream may be the same, substantially equal or different from a gaseous stream in an adjacent flow pathway. In an embodiment, the flow rates of the gaseous streams are substantially equal as they flow through their respective flow pathways and are substantially equal upon discharge from the coating apparatus 42.

In an embodiment, each flow pathway 54 - 66 has a slot-like configuration with a length which is preferably greater than its width. In another embodiment, at least one of the flow pathways 60 may be substantially straight. In other embodiments, at least one of the flow pathways 54 - 66 has a portion or portions which are substantially straight. In still further embodiments, at least one of the flow pathways 54, 56, 58, 62, 64, 66 may have a bend 74 connected to or connecting substantially straight portions of the flow pathway. In these embodiments, the flow pathway 54, 56, 58, 62, 64, 66 may have a plurality of bends 74. In still further embodiments, the flow pathways 28 are configured so that they are nearly identical in shape, length, and width. However, as depicted in Fig. 8, the widths of certain flow pathways may be the same or different from an adjacent flow pathway.

The coating apparatus 42 may comprise a plurality of baffle blocks 76. Preferably, a baffle block 76 is located in each flow pathway 54 - 66 between the cover block 53 and a flow conditioner 78. The baffle blocks 76 help to distribute the gaseous streams uniformly, or at least to increase the uniformity of the gaseous streams, in the flow pathways 54 - 66.

The coating apparatus 42 comprises one or more flow conditioners 78. Preferably, each stream is directed through a flow conditioner at a predetermined flow velocity to condition each stream, i.e. the flow conditioner 78 increases the laminarity of the gaseous precursor/inert gas stream that is directed through it. In certain embodiments, the flow conditioner provides the stream with a desired degree of laminarity or desired increase in laminarity.

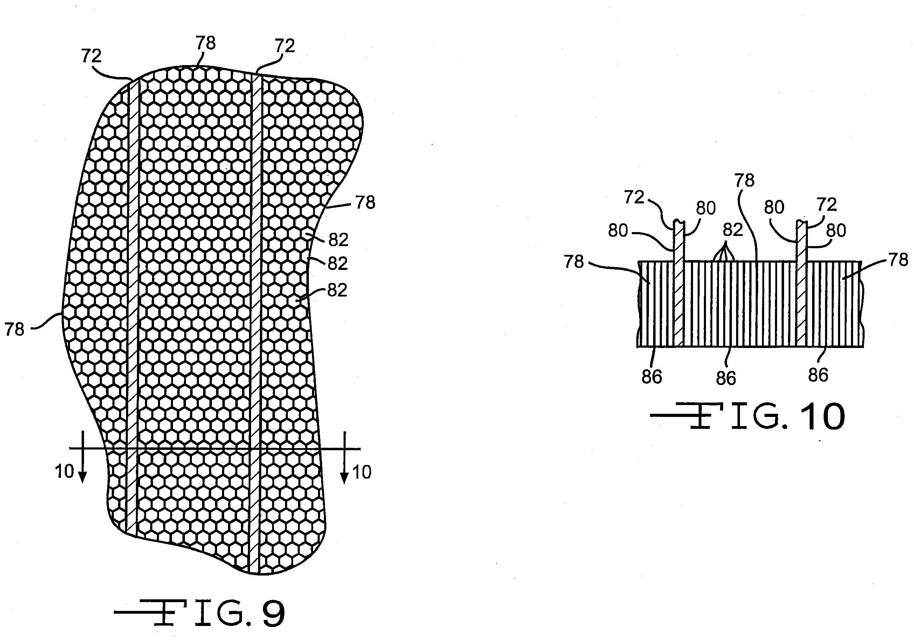

Thus, in certain embodiments, each flow pathway 28 has a flow conditioner 78 disposed therein. As such, a flow conditioner 78 may be positioned between a sidewall 46 of the main body 44 and a gas flow separator 72 or positioned between a pair of adjacent gas flow separators. As depicted in Fig. 10, in these embodiments, each flow conditioner 78 is attached preferably by a weld (not depicted) to a side 80 of at least one gas flow separator 72.

The vertical dimension or "thickness" of each flow conditioner 78 may vary depending upon the extent to which laminarity of the flow of a particular gaseous stream is desired to be increased. However, in an embodiment, the thickness of each flow conditioner 78 is from about 5 mm to about 25 mm. At least one of the one or more flow conditioners 78 has a "honeycomb" configuration.

An exemplary honeycomb configuration is shown in Fig. 9. A flow conditioner 78 having a honeycomb configuration may further increase the laminarity of a gaseous stream. As illustrated, a honeycomb configuration comprises a plurality of cells 82. The dimensions of the cells 82 of the honeycomb may vary in size and shape. A preferred area for each cell of the honeycomb configuration is about 1 mm². However, it should be appreciated that the invention is not limited to flow conditioners having a honeycomb configuration and that the dimensions provided to describe certain honeycomb configurations are also not limiting.

Each stream is discharged from the coating apparatus 42 through an outlet opening 70 at an end 84 of each flow pathway 54 - 66. Thus, each flow pathway 54 - 66 provides communication between an inlet opening 40 and an outlet opening 70. Preferably, each flow conditioner 78 is positioned adjacent the outlet opening 70 at the end 84 of each flow pathway 54 - 66. In these embodiments, the outlet opening 70 of the flow pathway may also be an outlet end 86 of the one or more flow conditioners 78. However, it may be advantageous to recess the outlet openings 70 from the at least one face 48 of the coating apparatus 42. In an embodiment, the distance from the at least one face 48 of the coating apparatus 42 to the outlet opening 70 of the flow pathways 54 - 66 may be from about 6.4 mm to about 102 mm and, preferably, is equal to or greater than 25.4 mm. Thus, the distance from the at least one face 48 of the coating apparatus 42 to the outlet end 86 of the one or more flow conditioners 78 may be from about 6.4 mm to about 102 mm and, preferably, is equal to or greater than 25.4 mm.

As above-discussed, in certain embodiments the widths of the flow pathways may be the same or different. As such, the widths of the outlet openings 70 may be the same or different. For example, as depicted in Fig. 7, an outlet opening 70 can have a width which is the same or substantially the same as the width of the adjacent outlet opening 70. In another embodiment and as depicted in Fig. 8, an outlet opening 70 can have a width which is larger than the width of the adjacent outlet opening 70.

As noted, the CVD process for depositing the zinc oxide coating comprises providing a gaseous zinc-containing compound, a gaseous oxygen-containing compound, and one or more gaseous additive compounds such as a gaseous acetonate compound and one or more inert gases. Optionally, a gaseous dopant compound may also be provided. A stream of at least one gaseous precursor compound or at least one inert gas is initiated and is conveyed through a supply line to at least one gaseous inlet opening 40. In an embodiment, the gaseous precursor compounds and the one or more inert gases are introduced as two or more streams into the inlet openings 40.

As the inlet openings are in communication with the flow pathways 54 - 66, the method also comprises directing the two or more streams through two or more separate flow pathways 54 - 66 in the coating apparatus 42. The streams flow at a predetermined velocity through a flow pathway 54 - 66. Also, the composition of a stream may be the same or different from a stream flowing through an adjacent flow pathway 54 - 66.

In order to avoid certain gaseous precursors compounds from prereacting, i.e. reacting before being discharged from the coating apparatus 42, it is preferred that certain gaseous precursor compounds are provided in separate streams. For example, preferably a stream comprising the gaseous zinc-containing compound is provided in a flow pathway and a stream comprising the gaseous oxygen-containing compound is provided in another flow pathway. Also, it may be preferable that the gaseous dopant compound and gaseous oxygen-containing compound are provided in separate streams and separate flow pathways.

Alternatively, in certain embodiments, it may be preferable that certain gaseous precursor compounds are provided in the same stream and therefore in the same flow pathway. For example, it may be preferable that the gaseous zinc-containing compound and the one or more gaseous additive compounds are included in the same stream and flow pathway. In this embodiment, a gaseous dopant compound may be included in the same or a separate stream as the gaseous zinc-containing compound.

In one embodiment, a gaseous stream comprising the gaseous zinc-containing compound is introduced into a first flow pathway 60 in the coating apparatus 42. In this embodiment, a gaseous stream comprising the gaseous oxygen-containing compound is introduced into a second flow pathway 56 in the coating apparatus 42 and a gaseous stream comprising inert gas is introduced into a third flow pathway 62 in the coating apparatus 42. Also, in this embodiment, a gaseous additive compound such as acetyl acetonate is introduced into a flow pathway 54 - 66 in the coating apparatus 42. In this embodiment, the third flow pathway 62 is located between the first and second flow pathways 60, 56. Also, in this embodiment, the coating apparatus 42 illustrated in Figs. 5-8 may be utilized.

As above-noted, suitable inert gases include N₂, H₂, He and mixtures thereof. In certain embodiments, a stream composed primarily of inert gas is introduced into at least one flow pathway in the coating apparatus 42. In these embodiments, the stream may act as a barrier stream. As a barrier stream, the inert gas(es) is provided in a flow pathway 62 located between flow pathways 56, 60 having streams comprising gaseous precursor compounds flowing there through.

In the CVD process described herein, mixing of the gaseous streams occurs by diffusion once the streams are discharged from the coating apparatus 42. Additionally, mixing of the gaseous streams begins very shortly after the gaseous streams are discharged from the coating apparatus 70. Since mixing of the gaseous streams occurs by diffusion, a barrier stream composed primarily of inert gas(es) delays the mixing of the gaseous precursor compounds. This delay can be attributed to the additional time/diffusion required for the gaseous precursor compounds to diffuse through the inert gas stream before mixing with each other. In certain embodiments, two or more streams composed primarily of inert gas(es) may be introduced into two or more separate flow pathways 58, 62 in the CVD process.

In an embodiment, the gaseous oxygen-containing compound may be provided in a stream which flows through a flow pathway 54, 56 which is at least partially defined by a sidewall 46 of the main body 44 and a gas flow separator 72. Furthermore, in certain embodiments, two flow pathways 54, 56 in the coating apparatus have a stream which comprises the gaseous oxygen-containing compound flowing there through.

In certain embodiments like those illustrated in Figs. 4-7, the coating apparatus comprises at least one exhaust gas passage 88. In these embodiments, the main body 44 may at least partially define the at least one exhaust gas passage 88. Each exhaust gas passage 88 includes an exhaust gas opening 90 which is provided near the surface 14 of the glass substrate 12 and extends through the main body 44. The exhaust gas passage 88 allows for the continuous removal of spent or unused gaseous precursor compounds and/or inert gases which might otherwise create undesired contaminants on the deposition surface of the substrate 14. Such gaseous exhaust extraction may also be utilized to influence the amount of gas flow turbulence and gaseous precursor/inert gas stream mixing which occurs at or near the deposition surface 14 of the glass substrate 12. Thus, the rate of exhaust extraction has the potential to effect the rate of coating deposition.

The CVD process for depositing the coating of zinc oxide also comprises discharging the streams from the outlet openings 70 of the coating apparatus 42 above the glass substrate 12. In certain embodiments, the coating apparatus 42 influences the rate at which the gaseous streams mix by controlling the flow path geometry of the streams after having been discharged therefrom. Thus, upon discharge from the coating apparatus 42, the streams of gaseous precursor compounds and inert gas are in still-separated flow paths as they proceed toward the deposition surface 14 of the substrate 12 for a time before they mix.

The discharge velocity and/or the flow rate of each gaseous stream may be selected to control the flow path geometry of the streams upon discharge from the coating apparatus 42. In an embodiment, the discharge velocity and/or the flow rate of each stream is selected to control the degree of turbulence between the streams and of the combined discharge of the streams. It should be appreciated that the higher the degree of turbulence, the greater the rate of mixing/diffusion between the streams once discharged from the coating apparatus 42. Thus, turbulence may have a significant influence on coating deposition rates and uniformity of coating thickness. In an embodiment, the gas flow velocity and/or the flow rate of a particular stream may be the same or different from one stream to the adjacent stream depending on the objective desired. However, it may be preferable that the gas flow velocities and/or the flow rates of the streams are substantially equal to each other in order to achieve an acceptably low amount of turbulence.

Preferably, after a particular stream has passed through a flow conditioner 78, the stream is discharged from the coating apparatus 42. However, in certain embodiments like the one illustrated in Fig. 6, after having passed through a flow conditioner 78 and been discharged from an outlet opening 70, the gaseous streams are still further physically separated as they flow through separate channels 92. In this embodiment, the streams of gaseous precursor compounds and inert gas(es) are further directed in still-separated flow pathways toward the deposition surface 14 of the substrate 12 by at least one gas discharge director 94. The at least one gas discharge director 94 comprises a thin projection extending a short distance from the respective outlet opening 70 and flow conditioner 78 toward the glass substrate 12.

Another method for controlling the flow path geometry once a stream has been discharged from the coating apparatus 10 is to control the temperature of the coating apparatus 10, particularly in the area proximate the flow conditioner 78 and the at least one gas discharge director 94 (if provided). Controlling the temperature of the coating apparatus 42, particularly in this area, assists in maintaining the structural integrity of the flow conditioner 78 and the at least one gas discharge director 94 when provided. Temperatures of the coating apparatus 42 are preferably controlled within + or - 50°F (10°C) of a predetermined set point temperature by any suitable means and may be controlled using a suitable heat transfer medium in certain portions 96 of the main body 44 of the coating apparatus 42.

The CVD process for deposition of the zinc oxide coating also comprises mixing the streams of gaseous precursor compounds/inert gas(es). As above-described, mixing of the gaseous streams occurs by diffusion and begins very shortly after the gaseous streams are discharged from the coating apparatus 42. Mixing of the streams begins before the gaseous precursor compounds/inert gas(es) contact the glass substrate surface 14 to be coated. Preferably, mixing of the streams of gaseous precursor compounds/inert gases occurs at or near the glass substrate surface 14. In certain embodiments, the mixing of the gaseous precursor compounds and inert gas(es) occurs in a space or mixing zone 98 above the surface 14 of the glass substrate 12. However, the gaseous precursor compounds react at or near the glass surface 14 to form a zinc oxide coating thereon.

The size and location of the mixing zone 98 may vary in embodiments of the CVD process. For example, in an embodiment, the mixing zone 98 may be located between the at least one face 48 of the main body 44 of the coating apparatus 42 and the surface 14 of the glass substrate 12. As diffusion of the gaseous precursor compounds and/or inert gas(es) may occur rapidly, in certain embodiments, a portion of the mixing zone 98 may be located adjacent the outlet openings 40 of the flow pathways 54 - 66 between the sidewalls 46 of the coating apparatus 42. In this embodiment, another portion of the mixing zone 98 may be located between the coating apparatus 42 and the surface 14 of the glass substrate 12.

For any particular combination of gaseous precursor compounds, the optimum concentrations and flow rates for achieving a particular deposition rate and zinc oxide coating thickness may vary. However, in certain embodiments, the composition of the gaseous mixture in the mixing zone 98 may comprise at least one alkyl zinc compound such as DMZ or DEZ, H₂O (in the form of steam), one or more additive compounds such as acetyl acetonate and inert gas(es). In other embodiments, the gaseous mixture in the mixing zone 98 may comprise at least one alkyl zinc compound such as DMZ or DEZ, H₂O (in the form of steam), one or more additive compounds such as acetyl acetonate, inert gas(es) and molecular oxygen in the form of O₂. In still further embodiments, the gaseous mixture in the mixing zone 98 may comprise at least one alkyl zinc compound such as DMZ or DEZ, H₂O (in the form of steam), one or more additive compounds such as acetyl acetonate, inert gas(es), molecular oxygen in the form of O₂ and a dopant compound such as a gallium-containing compound or an aluminum-containing compound. In this embodiment, the gaseous mixture may further comprise HCI as an additive compound.

As should be appreciated, for any particular combination of gaseous precursor compounds, the optimum concentrations and flow rates for achieving a particular deposition rate may be determined by trial or by computer modeling. It will also be appreciated that the use of higher concentrations of a particular gaseous reactant compound and higher flow rates may result in less efficient overall conversion of the reactants into a zinc oxide coating, so that the optimum conditions for commercial operation may differ from the conditions which provide the highest deposition rates.

In any of the embodiments of the above-described CVD process, mixing of the gaseous precursor compounds and one or more inert gases occurs to form a zinc oxide coating on a surface 14 of the glass substrate 12.

Utilizing the above-described CVD process results in the deposition of a high quality zinc oxide coating being formed on the glass substrate 12. In particular, the zinc oxide coating formed exhibits excellent coating thickness uniformity. For example, a coating of zinc oxide of 1000 nm or more can be deposited uniformly on the glass substrate 12.

As described, in certain embodiments the invention is directed to a process for depositing a zinc oxide coating on a glass substrate 12. Thus, in an embodiment, the zinc oxide coating is formed directly on the glass substrate 12. However, in other embodiments, the zinc oxide coating may be formed either directly on or over a previously deposited coating layer(s). For example, in certain embodiments, an iridescence-suppressing interlayer is formed on the surface 14 of the glass substrate 12 prior to forming the zinc oxide coating. The iridescence-suppressing interlayer is provided so that the coated glass article has a neutral color in transmittance and reflectance. As should be appreciated, the iridescence-suppressing interlayer may be a single coating layer or may comprise two or more discrete coating layers.

In certain embodiments, the CVD process includes the advantages of depositing a zinc oxide coating at commercially viable deposition rates, at temperatures which heretofore have not been possible and exhibiting certain desired properties.

As noted, a feature of the CVD process for depositing the coating of zinc oxide is that it allows for the formation of zinc oxide coatings at commercial viable deposition rates. High deposition rates are important when depositing coatings on a glass substrate 12. This is particularly true if the glass substrate 12 is a glass ribbon travelling at a line speed in the range of several hundred inches per minute and a zinc oxide coating of a specific thickness must be deposited in fractions of a second. For example, the CVD process allows for the formation of a zinc oxide coating at deposition rate of greater than 5 nanometers per second (nm/sec). Surprisingly, in other embodiments, the CVD process provides a zinc oxide coating deposition rate of greater than 50 nm/sec. Additionally, an advantage of the CVD process is that it is more efficient than known processes for depositing a zinc oxide coating. Thus, commercially viable deposition rates can be achieved using a lesser amount of gaseous reactant compounds than in known processes for forming a zinc oxide coating which reduces the cost to form such coatings. As should be appreciated, the zinc oxide coatings formed at these deposition rates may also be formed with desired properties.

As noted, the CVD process allows for the formation of zinc oxide coatings that exhibit desired properties. For example, as discussed, it may be desirable to impart the property of low electrical resistivity to a zinc oxide coating. In the CVD process described herein this can be accomplished, for example, by adding a suitable dopant to the zinc oxide coating. In certain embodiments, the coated glass articles formed by utilizing the CVD process may exhibit an electrical resistivity of less than 1.0x10-3 ohm cm. Additionally, in certain embodiments, the CVD process allows for the formation of zinc oxide coatings having high visible light transmission (Tvis). For example, zinc oxide coatings formed by the CVD process may exhibit Tvis values of greater than 60% and preferably greater than 70%.

Another feature of the CVD process is the ability to control the degree of haze that the zinc oxide coating exhibits. The degree of haze that the zinc oxide coating exhibits (as measured by the haze of the coated glass article the zinc oxide coating is formed on) can be varied by adjusting the amounts of certain gaseous precursor compounds in certain gaseous streams. For example, the coated glass articles formed by the CVD process may exhibit a haze value of between .3% and 20%. As should be appreciated, coated glass articles having a low haze value of, for example, below 1% or a high haze value of, for example, above 10% might be desirable depending on the application the particular coated glass article is utilized in.

As above-noted, in certain embodiments, the CVD process for depositing a zinc oxide coating may be practiced with a float glass manufacturing process. In an embodiment where the CVD process for depositing a zinc oxide coating is practiced at essentially atmospheric pressure and with a float glass manufacturing process, the molten glass 20 flows along the canal 18 beneath a regulating tweel 100 and downwardly onto the surface of the molten tin 32 in controlled amounts. On the molten tin 32, the molten glass 20 spreads laterally under the influence of gravity and surface tension, as well as certain mechanical influences, and it is advanced across the tin bath 32 to form the glass ribbon 24.

In this embodiment, the glass ribbon 24 is moving and heated and the separate gas flow streams are mixed in a desired mixing zone. The gaseous streams are delivered to the mixing zone 98 at a temperature below the temperature at which they react to form the zinc oxide coating and the glass ribbon is at a temperature above the reaction temperature. The gaseous precursor compounds chemically react in a predetermined manner and the reaction results in the deposition of a zinc oxide on the deposition surface 14 of the moving, heated glass substrate 12.

The glass ribbon 24 is removed from the float bath section 22 over lift out rolls 102 and is thereafter conveyed through the annealing lehr 26 and the cooling section 28 on aligned rolls. The deposition of the zinc oxide coating of the invention preferably takes place in the float bath section 22, although it may be possible for deposition to take place further along the glass production line, for example, in the gap 50 between the float bath section 22 and the annealing lehr 26, or in the annealing lehr 26.

A suitable non-oxidizing atmosphere, generally nitrogen or a mixture of nitrogen and hydrogen in which nitrogen predominates, is maintained in the float bath chamber 38 to prevent oxidation of the molten tin 32. The atmosphere gas is admitted through conduits 104 operably coupled to a distribution manifold 106. The non-oxidizing gas is introduced at a rate sufficient to compensate for normal losses and maintain a slight positive pressure, on the order of about 0.001 to about 0.01 atmosphere above ambient atmospheric pressure, so as to prevent infiltration of outside atmosphere.

In this embodiment, the CVD process of the present invention is an APCVD process. As such, for purposes of describing the present invention, the above-noted pressure range is considered to constitute normal atmospheric pressure. It should be noted that in addition to the pressure of the float bath chamber 38, the pressure of the annealing lehr 26 and/or or in the gap 50 between the float bath section 22 and the annealing lehr 26 may be at essentially atmospheric pressure and a coating apparatus 42 may be located therein to practice the CVD process. However, it should also be noted that the present invention is not limited to an APCVD process. Thus, the zinc oxide coating may be formed under low-pressure conditions.

Heat for maintaining the desired temperature regime in the molten tin 32 and the float bath chamber 38 is provided by radiant heaters 108 within the chamber 38. The atmosphere within the lehr 26 is typically atmospheric air, as the cooling section 28 is not enclosed and the glass ribbon 24 is therein open to the ambient atmosphere. Ambient air may be directed against the glass ribbon 24 as by fans 110 in the cooling section 28. Heaters may also be provided within the annealing lehr 26 for causing the temperature of the glass ribbon 24 to be gradually reduced in accordance with a predetermined regime as it is conveyed there through.

### EXAMPLES

A coating apparatus was utilized to deposit zinc oxide coatings on glass substrates transported through a belt conveyor furnace, more specifically, a three zone furnace, having a substrate heating zone, a coating zone, and a cool down zone. Sheets of soda-lime silica glass and soda-lime silica glass with a previously deposited silica coating layer thereon were loaded onto the conveying belt which passed through the furnace. For the Comparative Example and Examples 2, 3, 4, 5, 6-1,6-2, 7-1, and 7-2, the glass temperature was allowed to reach 650°C before entering the coating zone. For examples 8, 9, and 10, the glass temperature was allowed to reach 630°C before entering the coating zone.

The glass substrate was then passed under the coating apparatus. The faces of the main body of the coating apparatus were located approximately 4mm above the surface of the glass substrate. Deposition was conducted at the reported line speeds on glass sheets. For the Comparative Example and Examples 2, 3, 4, 5, 6-1,6-2, 7-1, and 7-2, the glass sheets had dimensions of 100 x 300 mm and a thickness of 3 mm. For the Examples 8, 9, and 10 the glass sheets had dimensions of 300 x 1200 mm and a thickness of 3.2 mm. Also, for the above-noted Comparative Example and Examples the coating apparatus was maintained at a temperature of 150°C. Substantially all of the input spent/unused gases were exhausted from the coating zone so as not to interfere with the deposition process.

As used in the Comparative Example and Examples below, the term "Slot" is equivalent to the term "flow pathway" used to above-describe the CVD process for depositing the zinc oxide coating.

### Comparative Example 1 - Zinc Oxide (ZnO) Deposition without an Additive Compound Using a 5 Slot Coating Apparatus

All gaseous precursor compound supply lines were maintained at above the dew point.

With Slot 1 being along the left side of the main body of the coating apparatus and Slot 5 being along the right side of the main body of the coating apparatus the streams provided in each of the slots were as follows:
Slot 1 and Slot 5 - Into these two slots a stream comprising a mixture of N₂ + H₂O (in the form of steam) was introduced. For simplicity, a single evaporator was used to create the steam and N₂ mixture which was equally divided and delivered as such to Slots 1 and 5. The steam and N₂ mixture was generated by injecting liquid water into a heated evaporator. N₂ carrier gas was added to the evaporator to convey the steam and N₂ mixture into Slots 1 and 5. 3 milliliters per minute (mL/min) of water was injected into the evaporator and mixed with N₂. The amount of N₂ added to the evaporator was such that the total flow of N₂ + steam was equal to 20 standard liters per minute (slm), with 10 slm going into each of Slots 1 and 5.
Slot 2 and Slot 4 - A metered stream comprising N₂ gas was introduced into each of Slots 2 and 4 at a flow rate of 10 slm. These inert gas streams delay the mixing the gaseous precursor compound flowing through Slot 3 and those flowing through Slots 1 and 5 when the gaseous precursor compounds/inert gases are discharged from the coating apparatus.

Into Slot 3 a stream comprising a mixture of DMZ and N₂ was introduced. The DMZ/N₂ mixture was generated by using a standard bubbler maintained at a temperature of 20°C. By passing a flow of He through the bubbler, a gas phase of 0.0087 mol/min of DMZ was evaporated and mixed with the N₂ to generate a stream with a total gas flow into and through Slot 3 of 10 slm.

Under the above-described conditions, at a line speed of 0.5 m/min, the glass substrates were conveyed under the coating apparatus. A zinc oxide coating having a thickness of 230 nm was deposited at a deposition rate of 10 nm/sec. This zinc oxide film exhibited high haze and poor bonding to the glass substrate surface.

### Example 2 - Zinc Oxide (ZnO) Deposition with an Additive Compound Using a 5 Slot Coating Apparatus

All gaseous precursor compound supply lines were maintained at above the dew point.

Slot 1 and Slot 5 - Using the experimental conditions described above in connection with Comparative Example 1, a stream comprising a gaseous mixture of N₂ and H₂O (in the form of steam) was introduced into and through Slot 1 and Slot 5. 10 mL/min of water was injected into the evaporator and the amount of N2 added to the evaporator was such that the total flow rate of N₂ and steam was equal to 20 slm, with 10 slm going to each stream in Slot 1 and Slot 5.

Slot 2 and Slot 4 - A stream of 10 slm of N₂ gas was introduced into each of Slots 2 and 4.

Slot 3 - The composition of the gaseous stream introduced into Slot 3 was modified from that of Comparative Example 1. In this example, the stream in Slot 3 comprised gaseous DMZ and an acetonate additive compound, namely acetyl acetonate. Two bubblers were used to generate a mixture of the two chemicals. Gaseous DMZ was generated by evaporation using a standard bubbler maintained at a temperature of 36°C. By passing a flow of He through the bubbler, 0.077 mol/min of gaseous DMZ was evaporated. A second standard bubbler which contained the acetyl acetonate was maintained at a temperature of 60°C. N₂ gas was passed through the second bubbler to generate a flow of acetyl acetonate. The two gaseous precursor compounds were mixed in a pipe, and additional N₂ was added to generate a stream which was introduced into Slot 3 having a total gas flow of 10 slm.

Under these conditions, glass sheets were moved under the coating apparatus at a line speed of 1.8 m/min. A 450 nm thick zinc oxide coating was deposited at a deposition rate of 68 nm/sec. The coated glass exhibited haze of 4.8% and visible light transmission of 76%.

### Example 3 - Gallium Doped Zinc Oxide (ZnO:Ga) Deposition with an Additive Compound Using a 5 Slot Coating Apparatus

All gaseous precursor compound supply lines were maintained at above the dew point.

Using the experimental conditions described above in connection with Example 2, a stream comprising a gaseous mixture of N₂ and H₂O (in the form of steam) was introduced into Slot 1 and Slot 5. To generate the stream, 24 mL/min of water was injected into the evaporator and 0.5 slm of N₂ was added. The total flow rate of the mixture was 20 slm with 10 slm of the mixture flowing through each of Slots 1 and 5.

Slot 2 and Slot 4 - A stream of 10 slm of N₂ gas was introduced into each of Slots 2 and 4.

The gaseous stream which was introduced into Slot 3 comprised a mixture of DMZ, acetyl acetonate and a dopant compound, namely TMG. Three bubblers were used to generate this gaseous stream mixture. The DMZ bubbler and the acetyl acetonate bubbler were operated as described in Example 2. DMZ was evaporated in a bubbler and transported through by He so that 0.077 mol/min of DMZ was evaporated. The TMG bubbler was maintained at a temperature of 10°C. N₂ gas was passed through the TMG bubbler to generate a flow of gallium-containing dopant compound. The three precursors were mixed in a pipe and additional N₂ added to create a total gas flow through Slot 3 of 10 slm. Under these conditions, glass sheets were moved under the coater at a line speed of 3.0 m/min where an electrically conductive zinc oxide coating having a thickness of 200-230 nm and exhibiting a resistivity on the order of 1x10-3 ohm cm was deposited at a deposition rate of 50-60 nm/sec.

It will be appreciated that by varying the concentrations of the DMZ/TMG in the stream which flowed through Slot 3, will produce zinc oxide coatings having a higher or a lower resistivity. For example, a resistivity of 1.3x10-2 ohm cm was exhibited by a film deposited using a gas phase of 0.002 mol/min of TMG while a resistivity of 4.3x10-3 ohm cm was exhibited by the coated glass using a gas phase of 0.004 mol/min of TMG. These coated glasses also exhibited high visible light transmission of 60-70 %, low IR radiation absorption of 13-20 %, and low haze of 0.6-1.1 %. By way of contrast, with no acetyl acetonate additive, zinc oxide coatings with much higher resistivites of 3.9x10-1 ohm cm and 9.3x10-2 ohm cm were obtained with the same amounts of gallium-containing dopant compound as noted above, respectively.

### Example 4 - Zinc Oxide (ZnO) Deposition with an Additive Compound Using a 5 Slot Coating Apparatus

All gaseous precursor compound supply lines were maintained at above the dew point.

A stream comprising a gaseous mixture of N₂ and H₂O (in the form of steam) was introduced into Slot 1 and Slot 5. To generate the stream, 19.5 cc/min of water was evaporated. N₂ was added so that the total flow rate of the mixture was 20 slm with 10 slm of the mixture flowing through each of Slots 1 and 5.

Slot 2 and Slot 4 - A stream of 10 slm of N₂ gas was introduced into each of Slots 2 and 4.

The gaseous stream which was introduced into Slot 3 comprised a mixture of DMZ and trifluoroacetylacetonate. The DMZ was evaporated so that 0.077 mol/min of gaseous DMZ was provided. The trifluoroacetylacetonate was evaporated so that 0.00092 mol/min of gaseous trifluoroacetylacetonate was provided. N₂ carrier gas was added to create a total gas flow through Slot 3 of 10 slm.

Under these conditions, glass sheets were moved under the coater at a line speed of 3.0 m/min where a zinc oxide coating having a thickness of 150 nm and deposited at a deposition rate of 37 nm/sec.

### Example 5 - Gallium Doped Zinc Oxide (ZnO:Ga) Deposition with an Additive Compound Using a 5 Slot Coating Apparatus

All gaseous precursor compound supply lines were maintained at above the dew point.

A stream comprising a gaseous mixture of N₂ and H₂O (in the form of steam) was introduced into Slot 1 and Slot 5. To generate the stream, 8 mL/min of water was evaporated. N₂ was added so that the total flow rate of the mixture was 20 slm with 10 slm of the mixture flowing through each of Slots 1 and 5.

Slot 2 and Slot 4 - A stream of 10 slm of N₂ gas was introduced into each of Slots 2 and 4.

The gaseous stream which was introduced into Slot 3 comprised a mixture of DMZ, acetyl acetonate and a dopant compound, namely TMG. The DMZ was evaporated so that 0.103 mol/min of gaseous DMZ was provided. The TMG was evaporated so that of 0.0047 mol/min of gaseous TMG was provided. The acetyl acetonate was evaporated so that of 0.00124 mol/min of gaseous acetyl acetonate was provided. The three precursors were mixed and additional N₂ added to create a total gas flow through Slot 3 of 10 slm.

Under these conditions, glass sheets were moved under the coater at a line speed of 3.0 m/min where an electrically conductive zinc oxide coating having a thickness of 363 nm and exhibiting a resistivity on the order of 8.4x10-3 ohm cm was deposited at a deposition rate of 91 nm/sec.

Furthermore, varying the amount of acetyl acetonate allows the haze value of the zinc oxide coatings to be adjusted such that zinc oxide coatings having higher and lower haze values can be formed. For example, a haze value of 1% was exhibited by the coated glass article having a zinc oxide coating deposited thereon under the above-described conditions. However, under substantially the same conditions, a coated glass article exhibited a haze value of 21% was formed by using a gas phase of 0.00049 mol/min of acetyl acetonate in the stream which flowed through Slot 3. This increase in haze was achieved with only a slight increase in the resistivity of the zinc oxide coating. Both coated glass articles also exhibited high visible light transmission of 60 and 68%, respectively.

The slots of the 7 slot coating apparatus utilized in Examples 6-1, 6-2, 7-1, 7-2, 8, 9, 10 will be described using a naming convention similar to those used to describe Comparative Example 1 and Examples 2 - 5, i.e. Slots 1 and 7 are at the left and right extremity of the coater, respectively.

### Example 6-1 - Gallium Doped Zinc Oxide (ZnO:Ga) Deposition with an Additive Compound Using a 7 Slot Coating Apparatus

All gaseous precursor compound supply lines were maintained at above the dew point.

Slot 1 and Slot 7 - Into these two slots a stream comprising a mixture of N₂ and H₂O (in the form of steam) was introduced. As in Example 1, a single evaporator was used to create the steam and N₂ mixture, which was equally split between Slots 1 and 7. 6 mL/min of water was injected into the evaporator. N₂ was again used as a carrier gas for the steam and N₂ mixture. The total flow rate was 20 slm with 10 slm of the steam and N₂ mixture flowing through each of Slots 1 and 7.

Slots 2, 3 and 5, 6 - A stream comprising N₂ at a metered flow of 5 slm was introduced into and flowed through each of slots 2, 3 and 5, 6.

Slot 4 - This slot was utilized to convey a stream comprising a mixture of DMZ, acetyl acetonate and TMG. A standard bubbler at 36°C was used to create gaseous DMZ which was transported through the bubbler by He so that 0.077 mol/min of DMZ was evaporated. A second standard bubbler at 60°C was again used to create gaseous acetyl acetonate which was transported through the bubbler by N₂. The third standard bubbler at a temperature of 10 C was again used to create gaseous TMG. The gaseous gallium-containing compound was transported through the bubbler by He so that 0.005 mol/min of TMG was evaporated. The three gaseous precursor compounds were mixed in a pipe and additional N₂ was added to create a total gas flow rate through Slot 4 of 10 slm.

Under these conditions, glass sheets were moved under the coater at a line speed from 0.5 to 3.0 m/min where an electrically conductive zinc oxide coating having a thickness of 280 - 1420 nm was deposited at a deposition rate of 60-70 nm/sec. Also, the zinc oxide coating exhibited a resistivity <1x10-3 ohm cm. Other properties exhibited by the coated glass include high visible light transmission >71%, and low haze < 2.0%. Again, it will be appreciated that by varying the concentrations of the DMZ and dopant in the gaseous mixture that films having a higher or a lower resistivity can be produced.

### Example 6-2 - Alternative Arrangement of Gaseous Precursor Compounds of Example 6-1 and Results Thereof using a 7 Slot Coating Apparatus

All gaseous precursor compound supply lines were maintained at above the dew point.

Slot 1 and Slot 7 - A stream of N₂ at a flow rate of 10 slm was introduced into each of these slots.

Slot 2 and Slot 6 - In this example, these two slots were utilized to convey a stream comprising a mixture of N₂ and H₂O (in the form of steam) in the same manner described for Example 6-1. A single evaporator was used to create the steam and N₂ mixture, which was equally split between streams introduced into Slots 2 and 6. 6 mL/min of water was injected into the evaporator. N₂ was again used as a carrier gas for the steam and N₂ mixture. The total flow was again 20 slm with each stream having a flow rate of 10 slm of the steam and N₂ mixture flowing through each of Slots 2 and 6.

Slots 3 and Slot 5 - A stream comprising a metered flow rate of 10 slm of N₂ carrier gas was introduced into each of these slots.

Slot 4 - This slot was again utilized to convey a stream comprising a mixture of DMZ, acetyl acetonate and TMG. A standard bubbler at 36°C was again used to evaporate DMZ which was transported through the bubbler by He so that 0.077 mol/min of DMZ was evaporated. A second standard bubbler at 60°C was again used to create gaseous acetyl acetonate which was evaporated and transported through the bubbler by N₂. A third standard bubbler at a temperature of 10°C was again used to create gaseous TMG which was transported through the bubbler by He so that 0.005 mol/min of TMG was evaporated. The three chemicals were mixed in a pipe and additional N₂ added to the stream for a total gas flow rate through Slot 4 of 13.5 slm.

Under these conditions, glass sheets were moved under the coating apparatus at a line speed of 3.0 m/min, where an electrically conductive zinc oxide coating having thickness of 570 nm and exhibiting a resistivity of 8.5x10-4 ohm cm was deposited at a deposition rate of 141 nm/sec. The coated glass article exhibited a Tvis of about 62% and a haze level of 7.7%.

### Example 7-1 - Gallium Doped Zinc Oxide (ZnO:Ga) Deposition with an Additive Compound Using a 7 Slot Coating Apparatus

All gaseous precursor compound supply lines were maintained at above the dew point.

Slot 1 and Slot 7 - Into these two slots a stream comprising a mixture of N₂ and H₂O (in the form of steam) was introduced. 6 mL/min of water was evaporated to create and provide steam. N₂ was added to the steam to form the mixture. The stream was equally split between Slots 1 and 7. The total flow rate was 20 slm with 10 slm of the steam and N₂ mixture flowing through each of Slots 1 and 7.

Slots 2 and 6 - A stream comprising N₂ at a metered flow of 5 slm was introduced into and flowed through each of slots 2 and 6.

Slots 3 and 5 - A stream of carrier gas and GaCl₃ was provided through these slots. The GaCl₃ was evaporated so that 0.0014 mol/min of gaseous GaCl₃ was provided. Additional carrier gas was added to create a total gas flow rate through Slots 3 and 5 of 5 slm.

Slot 4 - This slot was utilized to convey a stream comprising a mixture of DMZ and acetyl acetonate. The DMZ was evaporated so that 0.077 mol/min of gaseous DMZ was provided. The acetyl acetonate was evaporated so that 0.00098 mol/min of gaseous acetyl acetonate was provided. Additional carrier gas was added to create a total gas flow rate through Slot 4 of 10 slm.

Under these conditions, glass sheets were moved under the coater at a line speed of 3.0 m/min where an electrically conductive zinc oxide coating having a thickness of 400 nm was deposited. The zinc oxide coating exhibited a resistivity of 5.9x10-3 ohm cm.

### Example 7-2 - Gallium Doped Zinc Oxide (ZnO:Ga) Deposition with a Second Additive Compound Using a 7 Slot Coating Apparatus

All gaseous precursor compound supply lines were maintained at above the dew point.

Slot 1 and Slot 7 - Into these two slots a stream comprising a mixture of N₂, H₂O (in the form of steam) and HCI was introduced. 6 mL/min of water was evaporated to create and provide the steam and between 0.00035 and 0.00210 mol/min of HCI was evaporated to provide gaseous HCI. N₂ was used as a carrier gas was added to the mixture. The mixture was created and equally split between Slots 1 and 7. The total flow rate was 20 slm with 10 slm of the N₂, steam, HCI mixture flowing through each of Slots 1 and 7.

Slots 2 and 6 - A stream comprising N₂ at a metered flow of 5 slm was introduced into and flowed through each of slots 2 and 6.

Slots 3 and 5 - A stream of carrier gas and GaCl₃ was provided through these slots. GaCl₃ was evaporated so that between 0.0007 and 0.0014 mol/min of gaseous GaCl₃ was provided. Additional carrier gas was added to create a total gas flow rate through Slots 3 and 5 of 5 slm.

Slot 4 - This slot was utilized to convey a stream comprising a mixture of DMZ and acetyl acetonate. DMZ was evaporated so that 0.077 mol/min of gaseous DMZ was provided. acetyl acetonate was evaporated so that 0.00098 mol/min of acetyl acetonate was provided. Additional carrier gas was added to create a total gas flow rate through Slot 4 of 10 slm.

Under these conditions, glass sheets were moved under the coater at a line speed of 3.0 m/min where an electrically conductive zinc oxide coating having a thickness of from 450 - 730 nm was deposited. The zinc oxide coating exhibited a resistivity of between 9.2x10-4 and 1.5x10-3 ohm cm.

### Example 8 - Gallium Doped Zinc Oxide (ZnO:Ga) Deposition with an Additive Compound and a Second Oxygen-Containing Compound Using a 7 Slot Coating Apparatus

All gaseous precursor compound supply lines were maintained at above the dew point.

Slot 1 and Slot 7 - Into these two slots a stream comprising a mixture of N₂, H₂O (in the form of steam) and O₂ was introduced. 2.4 mL/min of water was evaporated to create and provide the steam. 0.50 cc/min of O₂ was provided. N2 carrier gas was added to the mixture so that the total flow rate was 14.2 slm with 7.1 slm of the N₂, steam, O₂ mixture flowing through each of Slots 1 and 7.

Slots 2 and 6 - A stream comprising N₂ at a metered flow of 7.1 slm was introduced into and flowed through each of slots 2 and 6.

Slots 3 and 5 - A stream comprising TMG and carrier gas at a flow of 7.1 slm was introduced into and flowed through each of slots 2 and 6. The TMG was evaporated so that 0.0045 mol/min of gaseous TMG was provided.

Slot 4 - This slot was utilized to convey a stream comprising a mixture of DMZ and acetyl acetonate. The DMZ was evaporated so that 0.045 mol/min of DMZ was provided. The acetyl acetonate was evaporated such that 0.0016 mol/min of gaseous acetyl acetonate was provided. The gaseous precursor compounds were mixed and additional carrier gas was added to create a total gas flow rate through Slot 4 of 7.1 slm.

Under these conditions, glass sheets were moved under the coater at a line speed of 5.1 m/min where an electrically conductive zinc oxide coating having a thickness of 174.3 nm was deposited at a deposition rate of 36.3 nm/sec. The zinc oxide coating exhibited a resistivity of 3.5x10-2 ohm cm. Other properties exhibited by the coated glass included a visible light transmission of 74% and a haze value of 0.5.

### Example 9 - Gallium Doped Zinc Oxide (ZnO:Ga) Deposition with an Additive Compound and a Second Oxygen-Containing Compound Using a 7 Slot Coating Apparatus

All gaseous precursor compound supply lines were maintained at above the dew point.

Slot 1 and Slot 7 - Into these two slots a stream comprising a mixture of N₂, H₂O (in the form of steam) and O₂ was introduced. 4.0 mL/min of water was evaporated to create and provide the steam. 0.50 cc/min of O₂ was provided. N₂ carrier gas was provided and added to the mixture so that the total flow rate was 14.2 slm with 7.1 slm of the N₂, steam, O₂ mixture flowing through each of Slots 1 and 7.

Slots 2 and 6 - A stream comprising N₂ at a metered flow of 7.1 slm was introduced into and flowed through each of slots 2 and 6.

Slots 3 and 5 - A stream comprising GaCl₃ and carrier gas at a flow of 7.1 slm was introduced into and flowed through each of slots 2 and 6. The GaCl₃ was evaporated so that 0.0045 mol/min of gaseous GaCl₃ was provided.

Slot 4 - This slot was utilized to convey a stream comprising a mixture of DMZ and acetyl acetonate. The DMZ was evaporated so that 0.045 mol/min of gaseous DMZ was provided and acetyl acetonate was evaporated so that 0.0022 mol/min of gaseous acetyl acetonate was provided. The gaseous precursor compounds were mixed and additional carrier gas was added to create a total gas flow rate through Slot 4 of 7.1 slm.

Under these conditions, glass sheets were moved under the coater at a line speed of 5.1 m/min where an electrically conductive zinc oxide coating having a thickness of 263.2 nm was deposited at a deposition rate of 54.8 nm/sec. The zinc oxide coating exhibited a resistivity of 1.9x10-2 ohm cm. Other properties exhibited by the coated glass included a visible light transmission of 68.3% and a haze value of 2.5.

### Example 10 - Zinc Oxide (ZnO) Deposition with an Additive Compound and a Second Oxygen-Containing Compound Using a 7 Slot Coating Apparatus

All gaseous precursor compound supply lines were maintained at above the dew point.

Slot 1 and Slot 7 - Into these two slots a stream comprising a mixture of N₂, H₂O (in the form of steam) and O₂ was introduced. 1.2 mL/min of water was evaporated to create and provide steam. 0.76 cc/min of O₂ was provided. N₂ carrier gas was added to the mixture so that the total flow rate was 14.2 slm with 7.1 slm of the N₂, steam, O₂ mixture flowing through each of Slots 1 and 7.

Slots 2, 3, 5 and 6 - A stream comprising N₂ at a metered flow of 7.1 slm was introduced into and flowed through each of slots 2, 3, 5 and 6.

Slot 4 - This slot was utilized to convey a stream comprising a mixture of DMZ and acetyl acetonate. The DMZ was evaporated so that 0.067 mol/min of gaseous DMZ was provided and acetyl acetonate was evaporated such that 0.0056 mol/min of gaseous acetyl acetonate was provided. The gaseous precursor compounds were mixed and additional carrier gas was added to create a total gas flow rate through Slot 4 of 7.1 slm.

Under these conditions, glass sheets were moved under the coater at a line speed of 5.1 m/min where a zinc oxide coating having a thickness of 178.9 nm was deposited at a deposition rate of 37.3 nm/sec. The coated glass exhibited a visible light transmission of 89.4% and a haze value of 1.6.

## Claims

1. A chemical vapor deposition process for depositing a zinc oxide coating comprising:
providing a glass substrate at a temperature above 1112°F (600°C);
providing a coating apparatus above the glass substrate, wherein the coating apparatus comprises two or more separate flow pathways, each flow pathway providing communication between an inlet opening and an outlet opening, and one or more flow conditioners disposed in each of the flow pathways;
providing gaseous precursor compounds including a gaseous zinc-containing compound, a gaseous oxygen-containing compound, and a gaseous acetonate compound and one or more inert gases;
introducing the gaseous precursor compounds and the one or more inert gases as two or more streams into the inlet openings;
directing the streams through the two or more separate flow pathways; and
discharging the streams from the outlet openings of the coating apparatus, wherein mixing of the gaseous precursor compounds and one or more inert gases occurs to form a zinc oxide coating on a surface of the glass substrate, wherein at least one of the one or more flow conditioners has a honeycomb configuration.

2. The process for depositing the zinc oxide coating defined in claim 1, wherein the gaseous zinc-containing compound is an alkyl zinc compound.

3. The process for depositing the zinc oxide coating defined in claim 1, wherein a stream comprising the gaseous zinc-containing compound is introduced into at least one flow pathway and a stream comprising the gaseous oxygen-containing compound is introduced into at least one separate flow pathway.

4. The process for depositing the zinc oxide coating defined in claim 1, wherein the zinc oxide coating is a pyrolytic coating and the glass substrate is moving when the zinc oxide coating is formed.

5. The process for depositing the zinc oxide coating defined in claim 1, wherein the acetonate compound is acetyl acetonate.

6. The process for depositing the zinc oxide coating defined in claim 1, further comprising directing each stream through the one or more flow conditioners to increase the laminarity of each stream.

7. The process for depositing the zinc oxide coating defined in claim 1, wherein the zinc oxide coating is formed on a glass ribbon in a float glass manufacturing process at essentially atmospheric pressure.

8. The process for depositing the zinc oxide coating defined in claim 1, wherein a stream comprises at least one gaseous dopant compound.

9. The process for depositing the zinc oxide coating defined in claim 1, wherein the coating apparatus comprises a main body which partially defines at least two flow pathways of the two or more separate flow pathways and at least one exhaust gas passage.

10. The process for depositing the zinc oxide coating defined in claim 1, wherein a stream comprising the gaseous zinc-containing compound and gaseous acetonate compound and a stream comprising the gaseous oxygen-containing compound are introduced into separate flow pathways in the coating apparatus.

11. The process for depositing the zinc oxide coating defined in claim 2, wherein the oxygen-containing compound is one selected from the group consisting of carbon dioxide, nitric oxide, nitrogen dioxide, nitrous oxide, oxygen and mixtures thereof.

12. The process for depositing the zinc oxide coating defined in claim 4, wherein the one or more inert gases are selected from the group consisting of nitrogen, hydrogen, helium and mixtures thereof.

13. The process for depositing the zinc oxide coating defined in claim 8, wherein the at least one gaseous dopant compound is a gallium-containing compound.

14. The process for depositing the zinc oxide coating defined in claim 8, wherein the at least one gaseous dopant compound is an aluminum-containing compound.

15. The process for depositing the zinc oxide coating defined in claim 13, wherein the stream comprising the gaseous gallium-containing compound further comprises gaseous HCI.

## Patentansprüche

1. Verfahren zur chemischen Gasphasenabscheidung zum Abscheiden einer Zinkoxidbeschichtung, das umfasst:
Bereitstellen eines Glasträgers bei einer Temperatur oberhalb von 1112 °F (600 °C);
Bereitstellen einer Beschichtungsvorrichtung oberhalb des Glasträgers, wobei die Beschichtungsvorrichtung zwei oder mehr als zwei getrennte Durchflusswege, wobei jeder Durchflussweg die Verbindung zwischen einer Einlassöffnung und einer Auslassöffnung herstellt, und einen oder mehrere Durchflussaufbereitungseinrichtungen umfasst, die in jedem der Durchflusswege angeordnet sind;
Bereitstellen gasförmiger Vorläuferverbindungen, die eine gasförmige zinkhaltige Verbindung, eine gasförmige sauerstoffhaltige Verbindung und eine gasförmige Acetonatverbindung und ein oder mehrere Inertgase einschließen;
Einleiten der gasförmigen Vorläuferverbindungen und des einen oder der mehreren Inertgase als zwei oder mehr als zwei Ströme in die Einlassöffnungen;
Hindurchleiten der Ströme durch die zwei oder mehr als zwei getrennten Durchflusswege; und
Hinausleiten der Ströme aus den Auslassöffnungen der Beschichtungsvorrichtung,
wobei das Mischen der gasförmigen Vorläuferverbindungen und des einen oder der mehreren Inertgase erfolgt, um eine Zinkoxidbeschichtung auf einer Oberfläche des Glasträgers zu bilden;
wobei mindestens eine der einen oder der mehreren Durchflussaufbereitungseinrichtungen eine Wabenstruktur hat.

2. Verfahren zum Abscheiden einer Zinkoxidbeschichtung, das in Anspruch 1 definiert ist, wobei die gasförmige zinkhaltige Verbindung eine Alkylzinkverbindung ist.

3. Verfahren zum Abscheiden einer Zinkoxidbeschichtung, das in Anspruch 1 definiert ist, wobei ein Strom, der die gasförmige zinkhaltige Verbindung umfasst, in mindestens einen Durchflussweg und ein Strom, der die gasförmige sauerstoffhaltige Verbindung umfasst, in mindestens einen getrennten Durchflussweg eingeleitet wird.

4. Verfahren zum Abscheiden einer Zinkoxidbeschichtung, das in Anspruch 1 definiert ist, wobei die Zinkoxidbeschichtung eine pyrolytische Beschichtung ist und der Glasträger in Bewegung ist, wenn die Zinkoxidbeschichtung erzeugt wird.

5. Verfahren zum Abscheiden einer Zinkoxidbeschichtung, das in Anspruch 1 definiert ist, wobei es sich bei der Acetonatverbindung um Acetylacetonat handelt.

6. Verfahren zum Abscheiden einer Zinkoxidbeschichtung, das in Anspruch 1 definiert ist, das weiterhin das Hindurchleiten jedes Stroms durch die eine oder die mehreren Durchflussaufbereitungseinrichtungen umfasst, um die Laminarität jedes Stroms zu erhöhen.

7. Verfahren zum Abscheiden einer Zinkoxidbeschichtung, das in Anspruch 1 definiert ist, wobei die Zinkoxidbeschichtung auf einem Glasband in einem Floatglasherstellungsverfahren im Wesentlichen bei Atmosphärendruck erzeugt wird.

8. Verfahren zum Abscheiden einer Zinkoxidbeschichtung, das in Anspruch 1 definiert ist, wobei ein Strom mindestens eine gasförmige Dotierungsverbindung umfasst.

9. Verfahren zum Abscheiden einer Zinkoxidbeschichtung, das in Anspruch 1 definiert ist, wobei die Beschichtungsvorrichtung einen Hauptkörper umfasst, der partiell mindestens zwei Durchflusswege der zwei oder mehr als zwei Durchflusswege und mindestens einen Abgasdurchlass definiert.

10. Verfahren zum Abscheiden einer Zinkoxidbeschichtung, das in Anspruch 1 definiert ist, wobei ein Strom, der die gasförmige zinkhaltige Verbindung und gasförmige Acetonatverbindung umfasst, und ein Strom, der die gasförmige sauerstoffhaltige Verbindung umfasst, in getrennte Durchflusswege in der Beschichtungsvorrichtung eingeleitet werden.

11. Verfahren zum Abscheiden einer Zinkoxidbeschichtung, das in Anspruch 2 definiert ist, wobei die sauerstoffhaltige Verbindung eine Verbindung ist, die aus der Gruppe ausgewählt wird, die aus Kohlendioxid, Stickstoffmonoxid, Stickstoffdioxid, Distickstoffmonoxid, Sauerstoff und Gemischen davon besteht.

12. Verfahren zum Abscheiden einer Zinkoxidbeschichtung, das in Anspruch 4 definiert ist, wobei das eine oder die mehreren Inertgase aus der Gruppe ausgewählt werden, die aus Stickstoff, Wasserstoff, Helium und Gemischen davon besteht.

13. Verfahren zum Abscheiden einer Zinkoxidbeschichtung, das in Anspruch 8 definiert ist, wobei die mindestens eine gasförmige Dotierungsverbindung eine galliumhaltige Verbindung ist.

14. Verfahren zum Abscheiden einer Zinkoxidbeschichtung, das in Anspruch 8 definiert ist, wobei die mindestens eine gasförmige Dotierungsverbindung eine aluminiumhaltige Verbindung ist.

15. Verfahren zum Abscheiden einer Zinkoxidbeschichtung, das in Anspruch 13 definiert ist, wobei der Strom, der die gasförmige galliumhaltige Verbindung umfasst, weiterhin gasförmiges HCl umfasst.

## Revendications

1. Procédé de dépôt chimique en phase vapeur pour déposer un revêtement d'oxyde de zinc comprenant :
la fourniture d'un substrat en verre à une température supérieure à 1 112°F (600°C) ;
la fourniture d'un appareil de revêtement au-dessus du substrat en verre, où l'appareil de revêtement comprend deux ou plusieurs trajectoires d'écoulement séparées, chaque trajectoire d'écoulement fournissant une communication entre une ouverture d'entrée et une ouverture de sortie, et un ou plusieurs conditionneurs d'écoulement disposés dans chacune des trajectoires d'écoulement ;
la fourniture de composés de précurseurs gazeux incluant un composé contenant du zinc gazeux, un composé contenant de l'oxygène gazeux, et un composé d'acétonate gazeux et un ou plusieurs gaz inertes ;
l'introduction des composés de précurseurs gazeux et des un ou plusieurs gaz inertes comme deux courants ou plus dans les ouvertures d'entrée ;
la direction des courants à travers les deux ou plusieurs trajectoires d'écoulement séparées ; et
la décharge des courants des ouvertures de sortie de l'appareil de revêtement,
où le mélange des composés de précurseurs gazeux et d'un ou plusieurs gaz inertes a lieu pour former un revêtement d'oxyde de zinc sur une surface du substrat en verre,
où au moins un du un ou plusieurs conditionneurs d'écoulement présente une configuration en nid d'abeilles.

2. Procédé pour le dépôt du revêtement d'oxyde de zinc défini dans la revendication 1, où le composé contenant du zinc gazeux est un composé d'alkyle zinc.

3. Procédé pour le dépôt du revêtement d'oxyde de zinc défini dans la revendication 1, où le courant comprenant le composé contenant du zinc gazeux est introduit dans au moins une trajectoire d'écoulement et un courant comprenant le composé contenant de l'oxygène gazeux est introduit dans au moins une trajectoire d'écoulement séparée.

4. Procédé pour le dépôt du revêtement d'oxyde de zinc selon la revendication 1, où le revêtement d'oxyde de zinc est un revêtement pyrolytique et le substrat en verre se déplace lorsque le revêtement d'oxyde de zinc est formé.

5. Procédé pour le dépôt du revêtement d'oxyde de zinc selon la revendication 1, où le composé d'acétonate est l'acétonate d'acétyle.

6. Procédé pour le dépôt du revêtement d'oxyde de zinc selon la revendication 1, comprenant de plus la direction de chaque courant à travers les un ou plusieurs conditionneurs d'écoulement pour augmenter la laminarité de chaque courant.

7. Procédé pour le dépôt du revêtement d'oxyde de zinc selon la revendication 1, où le revêtement d'oxyde de zinc est formé sur un ruban en verre dans un procédé de fabrication de verre flotté à pression pratiquement atmosphérique.

8. Procédé de dépôt du revêtement d'oxyde de zinc selon la revendication 1, où un courant comprend au moins un composé dopant gazeux.

9. Procédé pour le dépôt du revêtement d'oxyde de zinc selon la revendication 1, où l'appareil de revêtement comprend un corps principal qui définit partiellement au moins deux trajectoires d'écoulement des deux ou plusieurs trajectoires d'écoulement séparées et au moins un passage de gaz d'échappement.

10. Procédé pour le dépôt du revêtement d'oxyde de zinc selon la revendication 1, où un courant comprenant le composé contenant du zinc gazeux et un composé d'acétonate gazeux et un courant comprenant le composé contenant de l'oxygène gazeux sont introduits dans des trajectoires d'écoulement séparées dans l'appareil de revêtement.

11. Procédé pour le dépôt du revêtement d'oxyde de zinc selon la revendication 2, où le composé contenant de l'oxygène est un choisi dans le groupe constitué de dioxyde de carbone, oxyde nitrique, dioxyde d'azote, oxyde nitreux, oxygène et mélanges de ceux-ci.

12. Procédé pour le dépôt du revêtement d'oxyde de zinc selon la revendication 4, où le un ou plusieurs gaz inertes sont choisis dans le groupe constitué d'azote, hydrogène, hélium et mélanges de ceux-ci.

13. Procédé pour le dépôt du revêtement d'oxyde de zinc selon la revendication 8, où au moins un composé de dopant gazeux est un composé contenant du gallium.

14. Procédé pour le dépôt du revêtement d'oxyde de zinc selon la revendication 8, où le au moins un composé de dopant gazeux est un composé contenant de l'aluminium.

15. Procédé pour le dépôt du revêtement d'oxyde de zinc selon la revendication 13, où le courant comprenant le composé contenant du gallium gazeux comprend de plus du HCI gazeux.
